# EUROPÄISCHE PATENTSCHRIFT

(11) **EP 4 260 377 B1**
(45) Veröffentlichungstag und Bekanntmachung des Hinweises auf die Patenterteilung: **30.09.2026**
(21) Anmeldenummer: 21848248.7
(22) Anmeldetag: 14.12.2021
(51) Int. Cl.: H10F 71/00, H10F 77/20, H10P 14/60, H10P 14/692

(54) **VERFAHREN ZUR HERSTELLUNG EINES BOR-EMITTERS AUF EINEM SILIZIUM-WAFER**
METHOD FOR PRODUCING A BORON EMITTER ON A SILICON WAFER
PROCÉDÉ POUR PRODUIRE UN ÉMETTEUR DE BORE SUR UNE TRANCHE DE SILICIUM

(30) Priorität: 14.12.2020 DE 102020133390
(43) Veröffentlichungstag der Anmeldung: 18.10.2023
(73) Patentinhaber: Hanwha Q CELLS GmbH, 06766 Bitterfeld-Wolfen (DE)
(72) Erfinder: JARZEMBOWSKI, Enrico, 06766 Bitterfeld-Wolfen (DE); KAUERT, Maximilian, 06766 Bitterfeld-Wolfen (DE); PETERS, Stefan, 06766 Bitterfeld-Wolfen (DE)
(74) Vertreter: Adares PartGmbB
(86) Internationale Anmeldenummer: PCT/DE2021/101003
(87) Internationale Veröffentlichungsnummer: WO 2022/127992

(56) Entgegenhaltungen:
- EP-A1- 3 104 397
- CN-A- 107 507 887
- CN-A- 109 545 893
- CN-A- 110 459 643
- US-B2- 8 691 677

## Beschreibung

Die Erfindung betrifft ein Verfahren zur Herstellung eines Bor-Emitters auf einem Silizium-Wafer. Insbesondere betrifft die Erfindung ein Verfahren zur Herstellung eines Bor-Emitters auf einem Silizium-Wafer, das einen Schritt zur Bildung von Borsilikatglas aufweist. Die Herstellung von Bor-Emittern auf Silizium-Wafern spielt insbesondere bei der Herstellung von Wafer-Solarzellen eine Rolle.

Üblicherweise wird der Schritt zur Bildung von Borsilikatglas durch Reaktion der Edukte BBr₃ und O₂ und einer Oberfläche des Silizium-Wafers in einem Rohrofen durchgeführt. Bei der Reaktion von BBr₃ und O₂ wird B₂O₃ gebildet, das auf der Oberfläche des Silizium-Wafers kondensiert und mit der Oberfläche zu Bor-haltigem SiO₂ d.h. Borsilikatglas reagiert. Typischerweise strömen die gasförmigen Edukte während der Ausbildung von Borsilikatglas auf dem Silizium-Wafer ständig auf einer Seite des Rohrofens in den Rohrofen ein. Auf der anderen Seite des Rohrofens werden dann mittels einer Pumpe gasförmige Reaktionsprodukte oder Reste der gasförmigen Edukte aus dem Rohrofen entfernt. Dadurch ist die Verweildauer der Edukte in dem Rohrofen vergleichsweise gering und liegt typischerweise unterhalb von 60 Sek., was bei der Verwendung von BBr₃ und O₂ unproblematisch ist, weil die Reaktionszeit dieser Edukte nur wenige Sekunden beträgt. BBr₃ ist allerdings schwer handhabbar, weil es giftig und aggressiv ist.

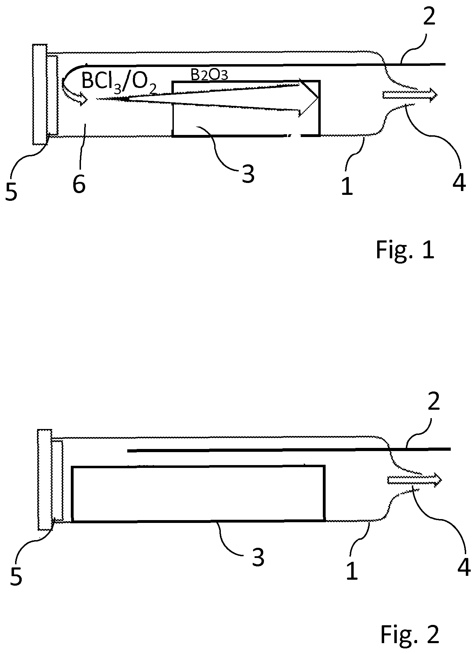

Aus der US 8,691,677 B2 ist ein Verfahren bekannt, bei dem zur Borsilikatglas-Ausbildung auf Silizium-Wafern BCl₃ und O₂ als Edukte verwendet werden. Zur Durchführung des Verfahrens werden die Silizium-Wafer in einem Rohrofen bereitgestellt, der in Fig. 1 gezeigt ist. Der Rohrofen 1 ist an einem Ende mittels einer Tür 5 verschließbar und an einem der Tür 5 gegenüberliegenden Ende 4 des Rohrofens 1 ist eine Pumpe (nicht gezeigt) angeordnet, um den Rohrofen 1 evakuieren zu können. In dem Rohrofen 1 sind weiterhin Zuführrohre 2 zum getrennten Zuführen von BCl₃ und O₂ angeordnet. Bei der Durchführung des Verfahrens werden Silizium-Wafer 3 durch die Tür 5 in den Rohrofen 1 geladen, so dass ein Totvolumen 6 zwischen den Silizium-Wafern 3 und der Tür 5 vorhanden ist. Die Edukte in Form von BCl₃ und O₂ und N₂ als Trägergas werden durch die Zuführrohre 2 derart in den Rohrofen 1 eingespült, dass sie in dem Totvolumen 6, das ein separiertes Reaktionsvolumen des Rohrofens 1 darstellt, getrennt von den Silizium-Wafern 3 zur Reaktion gebracht werden. Die dabei entstehenden Produkte u.a. B₂O₃ werden dann in einem kontinuierlichen Fluss über die Silizium-Wafer 3 geleitet und zur Ausbildung des Borsilikatglases auf den Silizium-Wafern verwendet. Die Richtung der bei der Durchführung strömenden Fluide ist durch die Pfeile angedeutet. Gegenüber BBr₃ als Edukt bringt die Verwendung von BCl₃ als Edukt diverse Vorteile mit sich, weil es eine geringere Giftigkeit, Aggressivität und bessere Handhabung bietet. Die Reaktionszeit von BCl₃ und O₂, um B₂O₃ zu bilden, die bei ca. 100 Sek. liegt, ist jedoch im Vergleich mit der Reaktionszeit von BBr₃ und O₂, die ca. 6 Sek. beträgt, deutlich länger. Die typische Verweilzeit der Edukte im Rohrofen beträgt jedoch ca. 60 Sek. Daher kann die Reaktion von BCl₃ und O₂ nur unvollständig und sehr inhomogen über die Länge des Rohrofens 1 stattfinden. Dadurch, dass die Reaktion im Totvolumen 6 durchgeführt wird und die durch die Reaktion von BCl₃ und O₂entstehenden Produkte erst anschließend über die Silizium-Wafer 3 geleitet werden, ist die Verweildauer zwar relativ lang, aber die Abscheidungsrate ist gering und die entstehenden Abscheidungen sind inhomogen.

Ferner beschreibt CN 1 10 459 643 A ein Verfahren, bei dem in einem Schritt S1 ein Siliziumsubstrat in einen Diffusionsofen eingebracht wird, der dann auf einen vorbestimmten Druck gebracht wird. Dann wird in einem Schritt S2 auf eine erste Temperatur erhitzt, und BCl₃, N₂ und O₂ werden eingespült. Dann wird in einem Schritt S3 auf eine zweite Temperatur erhitzt, und das Einspülen von BCl₃ und O₂ wird gestoppt, so dass nur mit N₂ gespült wird. Nachdem Schritte S2 und S3 mehrere Male wiederholt worden sind, wird nach dem Schritt S2 die Temperatur erhöht und die Zufuhr von BCl₃ und O₂ gestoppt und der Zustand über eine Zeit aufrechterhalten, bis der Druck im Diffusionsofen verändert wird und N₂ und O₂ zum Oxidieren einspült werden. Anschließend wird der Siliziumwafer auf dem Diffusionsofen entfernt.

CN 1 09 545 893 A beschreibt ein Verfahren zur Herstellung eines Boremitters, bei dem in einem Schritt ein Siliziumwafer in einen Diffusionsofen eingebracht wird, auf eine stabile Temperatur im Bereich von 850 bis 870°C gebracht wird, eine vorbestimmte Menge einer Borquelle vor-abgeschieden wird, dann eine bestimmte Menge einer Borquelle unter Stabilisieren mit Sauerstoff abgeschieden wird, und das Bor anschließend durch Temperaturerhöhung eingetrieben wird.

CN 1 07 507 887 A beschreibt ein Verfahren, bei dem Wafer einer stufenweisen Abscheidung mit einem Temperaturgradienten von einem Ofenende zum Ofeneingang ausgesetzt werden, die zwei Niedrigtemperatur-Schritte aufweisen, in denen N₂, O₂ und Dotiergas zur Vorabscheidung bzw. Abscheidung eingespült werden.

Aus der US 8 691 677 B2 ist ein Verfahren bekannt, bei dem Silizium-Wafer in einem Rohrofen bereitgestellt werden, und BCl₃ und O₂ getrennt voneinander zugeführt und in einem Totvolumen benachbart zu den Siliziumwafern zur Reaktion gebracht werden und dann über diese geleitet werden.

EP 3 104 397 A1 beschreibt ein Verfahren zum Dotieren von Siliziumwafern in einem Diffusionsofen, bei dem Siliziumwafer in den Ofen eingebracht werden, auf eine vorbestimmte Temperatur gebracht werden und Reaktionsgas, Dotiergas und Trägergas gleichzeitig in den Ofen eingespült werden, wobei ein Verhältnis von Reaktionsgas zu Dotiergas während der gleichzeitigen Zufuhr und ein Fluss des Trägergases variiert werden.

Es ist eine Aufgabe der Erfindung, ein Verfahren zur Herstellung eines Bor-Emitters auf einem Silizium-Wafer, bereitzustellen, das einen Schritt zur Bildung von Borsilikatglas aufweist, wobei eine homogene Abscheidung und/oder eine hinreichend hohe Abscheidungsrate erzielt werden.

Erfindungsgemäß wird die Aufgabe durch ein Verfahren mit den Merkmalen des Patentanspruchs 1 gelöst. Vorteilhafte Weiterbildungen und Modifikationen sind in den Unteransprüchen angegeben.

Die Erfindung betrifft ein Verfahren zur Herstellung eines Bor-Emitters auf mindestens einem Silizium-Wafer, der in einem Rohrofen angeordnet ist, aufweisend einen Schritt zur Bildung von Borsilikatglas auf dem Silizium-Wafer, aufweisend in der angegebenen Reihenfolge
a) Evakuieren des Rohrofens auf einen vorbestimmten Druck,
b) Einspülen von Edukten, aufweisend BCl₃ und O₂, in den Rohrofen und Einstellen auf einen weiteren vorbestimmten Druck,
c) Stoppen des Einspülens nach Ablauf einer vorbestimmten Zeit und Reagierenlassen der eingespülten Edukte mit sich und einer Oberfläche des Silizium-Wafers (3) über eine vorbestimmte Zeitdauer, um eine Schicht mit Borsilikatglas auf der Oberfläche des Silizium-Wafers (3) auszubilden, und
d) Evakuieren des Rohrofens nach Ablauf der vorbestimmten Zeitdauer.

Die Erfindung basiert auf dem Grundgedanken, die Konzentration von B₂O₃ im Rohrofen relativ konstant zu halten und darüber eine homogene Abscheidung sowie eine vollständigere Reaktion zu erzielen. Dies wird dadurch realisiert, dass der Schritt zur Ausbildung von Borsilikatglas auf dem Silizium-Wafer mehrstufig ausgeführt wird. Der Verfahrensschritt des Einspülens der Edukte wird von dem Verfahrensschritt der Edukt-Reaktion im Wesentlichen entkoppelt. Dies geschieht dadurch, dass zunächst die Edukte in definierten Mengen und mit definierten Flussraten in den Rohrofen eingespült werden. Anschließend wird das Einströmen der Edukte gestoppt und im Rohrofen als geschlossenem System läuft die Reaktion der Edukte ab. Dadurch ist es möglich, die Edukte in der Umgebung des Silizium-Wafers reagieren zu lassen, so dass eine homogenere Abscheidung von Borsilikatglas auf den Silizium-Wafern erzielt wird. Anschließend werden bei der Reaktion entstehende Reaktionsprodukte und ggf. nicht abreagierte Edukte aus dem Rohrofen entfernt. Durch die weitgehende Trennung des Einspülens der Edukte von der Reaktion der Edukte ist es möglich, die beiden Schritte einzeln zeitlich so gesteuert und optimiert durchzuführen, dass die Abscheidungsrate und Abscheidungsqualität erhöht werden. Die Homogenität der Abscheidung lässt sich beispielsweise über eine Messung eines Emitter-Schichtwiderstands ermitteln.

Die Fluidflusszyklen der Edukte und der Produkte werden jeweils in einzelnen, voneinander getrennten Schritten gesteuert. Zuerst wird in dem Schritt b) der Fluidzufluss der Edukte gesteuert, während in dem Schritt c) die Reaktion der Edukte gesteuert wird und in dem Schritt d) der Fluidausfluss aus Reaktionsprodukten und ggf. nicht abreagierten Edukten gesteuert wird. Jeder Schritt ist für sich einzeln in seinen Verfahrensparametern einstellbar, so dass das Verfahren insgesamt optimiert abläuft.

Der Schritt a) dient insbesondere dazu, den Schritt b) dahingehend vorzubereiten, dass in dem Schritt b) eine definierte Menge an Sauerstoff in den Rohrofen eingespült wird. Der Schritt d) dient insbesondere dazu, Abbau- und/oder Erschöpfungseffekten der sich in dem Rohrofen befindenden Fluide vorzubeugen.

In dem Schritt b) werden BCl₃ und O₂ in den Rohrofen eingespült. Weiterhin kann ein Trägergas insbesondere für BCl₃ in dem Schritt b) in den Rohrofen eingespült werden. Bevorzugt kommt als Trägergas N₂ zum Einsatz. Mit der Formulierung "Stoppen des Einspülens" ist gemeint, dass keine weiteren Edukte mehr in den Rohrofen einströmen, sondern die Zufuhr der Edukte unterbunden wird. In dem Schritt b) wird der Rohrofen bevorzugt auch nicht evakuiert. D.h. eine zur Evakuierung des Rohrofens vorgesehen Pumpe ist in dem Schritt b) inaktiviert bzw. ausgeschaltet. Der Rohrofen bildet in dem Schritt b) ein geschlossenes System. Dem geschlossenen System werden Fluide weder aktiv zugeführt noch aktiv aus ihm entfernt.

Das bei der Reaktion von BCl₃ und O₂ entstehende B₂O₂ ist unter den im Rohrofen bei dieser Reaktion herrschenden Bedingungen eine Flüssigkeit, das in dem Rohrofen als Aerosol vorliegt.

Die Formulierung "Evakuieren des Rohrofens" in dem Schritt d) bedeutet, dass der Druck in dem Rohrofen auf einen Wert von 0 mbar, bis zu 1mbar, bevorzugt bis zu 10 mbar gebracht wird.

Um die Schritte a) bis d) auszuführen weist der Rohrofen, der für das Verfahren zum Einsatz kommt, bevorzugt eine Tür auf, durch die der mindestens eine Silizium-Wafer in den Rohrofen geladen wird. Weiterhin ist eine an einer der Tür gegenüberliegenden Seite angeordnete Pumpe vorgesehen, die ausgebildet ist, den Rohrofen zu evakuieren, Zuführrohre, die ausgebildet sind, die Edukte einzeln und gegebenenfalls mittels eines Trägergases zuzuführen. Sowie ist eine Heizeinrichtung vorgesehen, die ausgebildet ist, den Rohrofen auf die gewünschte Reaktionstemperatur zu erhitzen.

Bevorzugt werden die Schritte b) bis d) zyklisch wiederholt. Dadurch kann eine gewünschte Menge an Borsilikatglas auf einfache Weise erzeugt werden. Beispielsweise werden die Schritte b) bis d) zwei- bis viermal wiederholt.

In einer bevorzugten Ausführungsform beträgt der vorbestimmte Druck bis zu 15 mbar, bevorzugt 1 bis 14 mbar, bevorzugter 7 bis 12 mbar. Dadurch wird sichergestellt, dass sich in dem Rohrofen kein Sauerstoff oder Luft oder sonstige unerwünschte Fluide befinden. Vor und/oder während des Schritts a) kann der Rohrofen mit einem Intertgas wie N₂ gespült werden. Dadurch wird weiterhin sichergestellt, dass sich kein O₂ in dem Rohrofen befindet.

Der weitere vorbestimmte Druck ist bevorzugt höher als der vorbestimmte Druck. Bevorzugt liegt der weitere vorbestimmte Druck im Bereich von 20 bis 200 mbar, bevorzugt 20 bis 170 mbar, bevorzugter 20 bis 150 mbar.

In einer bevorzugten Ausführungsform wird der Schritt c) bei einer Temperatur im Bereich von 800 bis 1.000°C, bevorzugt 820 bis 950°C, bevorzugter 850 bis 910°C durchgeführt.

Bevorzugt liegt die vorbestimmte Zeit im Bereich von 10 bis 120 Sek., bevorzugt im Bereich von 20 bis 100 Sek., bevorzugter im Bereich von 30 bis 60 Sek. durchgeführt. Bevorzugt liegt die vorbestimmte Zeitdauer im Bereich von 2 Min. bis 20 Min., besonders bevorzugt im Bereich von 3 Min. bis 15 Min. und noch bevorzugter 5 Min. bis 10 Min. Das Einspülen der Edukte und ggf. des Trägergases in dem Schritt b) wird relativ rasch durchgeführt, während den Edukten in dem Schritt b) eine dazu vergleichsweise lange Reaktionszeit gewährt wird. Dies hat den Hintergrund, dass die Abscheidung, die durch die Reaktion erfolgt, möglichst unter konstanten und gleichbleibenden Bedingungen stattfindet. Dadurch wird eine hinreichend homogene Abscheidung erzielt.

Bevorzugt wird der Schritt a) in einer weiteren Zeit im Bereich von 10 bis 120 Sek., besonders bevorzugt im Bereich von 20 bis 100 Sek. und noch bevorzugter im Bereich von 30 bis 60 Sek. durchgeführt. Die Evakuierungszeit ist relativ kurz. Dadurch werden Zeit und Kosten gespart.

Bevorzugt wird der Schritt d) in einer noch weiteren Zeit im Bereich von 10 bis 120 Sek., bevorzugt im Bereich von 20 bis 100 Sek., noch bevorzugter im Bereich von 30 bis 60 Sek. durchgeführt. Die relativ schnelle Evakuierung des Rohrofens in dem Schritt d) dient zur Vermeidung eines Depletion-Effektes der sich in dem Rohrofen befindenden Fluide. Die Fluide werden dann relativ rasch aus dem Rohrofen entfernt.

In einer bevorzugten Ausführungsform werden die Edukte in dem Schritt b) derart in den Rohrofen eingespült, dass BCl₃ durch ein Zuführrohr mit einem Austrittsende in den Rohrofen eingespült wird und O₂ durch ein weiteres Zuführrohr mit einem Austrittsende in den Rohrofen eingespült wird, so dass sich BCl3 und O2 in dem Rohrofen an den benachbart zueinander angeordneten Austrittsenden des Zuführrohrs und des weiteren Zuführrohrs in dem Rohrofen mischen. Die Austrittenden sind bevorzugt benachbart zueinander angeordnet, so dass die Edukte bei Eintritt in den Rohrofen rasch reagieren können. In dem Sinne der Erfindung bedeutet der Ausdruck "benachbart" weniger als 1cm Abstand zwischen den Mittelpunkten der Austrittsenden beider Zuführrohre.

In einer bevorzugten Ausführungsform mischen sich die Edukte in dem Schritt b) in einem Bereich des Rohrofens, in dem der mindestens eine Silizium-Wafer angeordnet ist. Dadurch reagieren die Edukte in unmittelbarere Nähe zu dem Silizium-Wafer. Dadurch wird eine Weglänge minimiert, die das B₂O₃ zurücklegen muss, um mit der Oberfläche des Silizium-Wafers zu reagieren. Dadurch wird weiterhin eine homogenere Abscheidung erzielt. Insbesondere befindet sich kein wesentlicher Totraum zwischen einer Tür des Rohrofens, durch die ein Waferboot mit einer Vielzahl darauf angeordneter Halbleiter-Wafer in den Ofen geladen wird, und dem Wafer-Boot. D.h., der Totraum zwischen dem Wafer-Boot und der Tür ist deutlich kürzer als 10% der Länge des Waferbootes.

Bevorzugt sind während des Verfahrens mehrere Silizium-Wafer in einem Waferboot in dem Rohrofen angeordnet, wobei der Abstand der Silizium-Wafer zueinander weniger als 5 mm und bevorzugt weniger als 3 mm beträgt. Dadurch ist das Verfahren weiterhin effizient und für die Massenproduktion geeignet. Der Rohrofen ist ein Diffusionsofen.

In einer bevorzugten Ausführungsform wird zwischen den Schritten c) und d) ein weiterer Schritt durchgeführt, bei dem der Rohrofen mit einem Inertgas wie N₂ gespült wird. Das Spülen mit dem Inertgas wird bevorzugt in einem Zeitraum von 10 bis 120 Sek., besonders bevorzugt im Bereich von 20 bis 100 Sek. und noch bevorzugter im Bereich von 30 bis 60 Sek. durchgeführt.

Das mittels der Schritte a) bis d) auf einer Oberfläche des Silizium-Wafers erzeugte Borsilikatglas dient als Dotierquelle zur Bildung des Bor-Emitters. Bevorzugt werden zur Herstellung des Bor-Emitters auf dem Silizium-Wafer nach dem Schritt d) ein Schritt e) Eintreiben von N₂ und nach dem Schritt e) ein Schritt f) Oxidation mit O₂ durchgeführt.

Der Schritt e) wird bevorzugt in einer Atmosphäre aus reinem N₂ durchgeführt, wobei der Ausdruck "rein" bedeutet, dass das N₂ höchstens technische Verunreinigungen aufweisen darf. Der Schritt e) wird bevorzugt bei einem Druck im Bereich von 600 bis 1000 mbar, besonders bevorzugt im Bereich von 700 bis 900 mbar und noch bevorzugter im Bereich von 750 bis 850 mbar durchgeführt. Weiterhin wird der Schritt e) bevorzugt bei einer Temperatur von 850 bis 1150°C, besonders bevorzugt im Bereich von 900 bis 1100°C und noch bevorzugter von 950 bis 1050°C durchgeführt.

Der Schritt f) wird bevorzugt unter Verwendung eines N₂/O₂-Gemisches durchgeführt. Eine O₂-Konzentration in dem N₂/O₂-Gemisch beträgt bevorzugt 40 bis 100%, besonders bevorzugt 45 bis 100% und noch bevorzugter 50 bis 100%. Bevorzugt wird der Schritt f) bei einer Temperatur im Bereich von 850 bis 1150°C, besonders bevorzugt im Bereich von 900 bis 1100°C und noch bevorzugter im Bereich von 950 bis 1050°C durchgeführt.

Nachfolgend wird die Erfindung anhand von Figuren detaillierter erläutert. Die Figuren zeigen schematisch und nicht maßstabsgerecht:
- Fig. 1: eine Querschnittsansicht eines Rohrofens, der gemäß Stand der Technik bei einem Verfahren zur Herstellung eines Bor-Emitters auf einem Silizium-Wafer eingesetzt wird;
- Fig. 2: eine Querschnittsansicht eines Rohrofens, der bei einem erfindungsgemäßen Verfahren zur Herstellung eines Bor-Emitters auf einem Silizium-Wafer eingesetzt wird; und
- Fig. 3: ein Verfahrensablaufdiagramm des erfindungsgemäßen Verfahrens.

Fig. 1 zeigt eine Querschnittsansicht eines Rohrofens, der gemäß Stand der Technik bei einem Verfahren zur Herstellung eines Bor-Emitters auf einem Silizium-Wafer eingesetzt wird. Zur Erläuterung des in Fig. 1 gezeigten Rohrofens wird auf den in der Beschreibungseinleitung dargestellten Stand der Technik verwiesen.

Fig. 2 zeigt eine Querschnittsansicht eines Rohrofens, der bei einem erfindungsgemäßen Verfahren zur Herstellung eines Bor-Emitters auf einem Silizium-Wafer eingesetzt wird. Der in Fig. 2 gezeigte Rohrofen 1 entspricht dem in Fig. 1 gezeigten Rohrofen mit dem Unterschied, dass er kein Totvolumen aufweist. Vielmehr werden in dem Schritt zur Ausbildung von Borsilikatglas auf dem Silizium-Wafer die Edukte BCl₃ und O₂ und ggf. N₂ als Trägergas derart in den Rohrofen 1 eingespült, dass BCl₃ durch ein Zuführrohr 2 in den Rohrofen 1 eingespült wird und O₂ durch ein weiteres Zuführrohr (nicht gezeigt) in den Rohrofen 1 eingespült wird, so dass sie sich in dem Rohrofen 1 an den Austrittsenden (nicht gezeigt) des Zuführrohrs 2 und des weiteren Zuführrohrs in dem Rohrofen 1 mischen, wobei die Edukte in den Rohrofen 1 derart eingespült werden, dass sie sich in einem Bereich des Rohrofens 1 mischen, in dem die Silizium-Wafer 3 angeordnet sind, um dort miteinander zu reagieren. Die Austrittsenden sind benachbart zueinander angeordnet. Nach dem Stoppen des Einspülens nach Ablauf einer vorbestimmten Zeit und dem Reagierenlassen der eingespülten Edukte mit sich und einer Oberfläche des Silizium-Wafers über eine vorbestimmte Zeitdauer, um Borsilikatglas auf der Oberfläche des Silizium-Wafers abzuscheiden, wird der Rohrofen 1 mittels Aktivierens der an dem Ende 4 des Rohrofens 1 angeordneten Pumpe (nicht gezeigt) evakuiert, wobei Produkte und ggf. nicht abreagierte Edukte in Pfeilrichtung aus dem Rohrofen 1 entfernt werden.

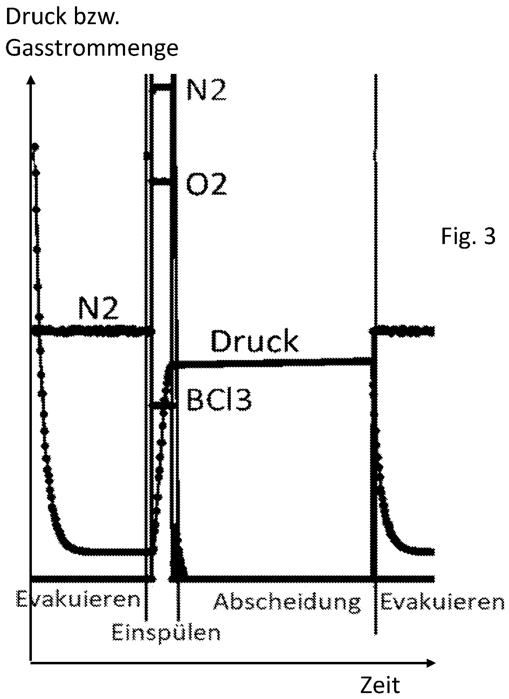

Fig. 3 zeigt ein Verfahrensablaufdiagramm des erfindungsgemäßen Verfahrens. Gezeigt ist eine zeitliche Abfolge des Verfahrens im Hinblick auf Druck- und Fluid- bzw. Gaszufuhrverhältnisse in dem in Fig. 2 gezeigten Rohrofen. Der Verfahrensablauf ist rein schematisch gezeigt, daher sind keine Einheiten an den Achsen angegeben. Das erfindungsgemäße Verfahren zur Herstellung eines Bor-Emitters auf einem Silizium-Wafer, der in dem in Fig. 2 gezeigten Rohrofen angeordnet ist, weist einen Schritt zur Bildung von Borsilikatglas auf dem Silizium-Wafer auf, der mehrstufig ausgebildet ist. Dieser Schritt weist in der angegebenen zeitlichen Reihenfolge auf:
a) Evakuieren des Rohrofens auf einen vorbestimmten Druck, wobei optional gleichzeitig Stickstoff in den Rohrofen eingespült werden kann,
b) Einspülen von Edukten, aufweisend BCl₃ und O₂, und N₂ als Trägergas in den Rohrofen und Einstellen auf einen weiteren vorbestimmten Druck, der größer ist als der vorbestimmte Druck in dem Schritt a), wobei die Gasstrommenge von O₂ größer ist als die Gasstrommenge von BCl₃,
c) Ausbildung des Borsilikatglases mittels Stoppens des Einspülens nach Ablauf einer vorbestimmten Zeit und Reagierenlassen der eingespülten Edukte mit sich und einer Oberfläche des Silizium-Wafers über eine vorbestimmte Zeitdauer, um Borsilikatglas auf der Oberfläche des Silizium-Wafers abzuscheiden, und
d) Evakuieren des Rohrofens nach Ablauf der vorbestimmten Zeitdauer.

Dabei ist die vorbestimmte Zeitdauer wesentlich größer ist als die vorbestimmte Zeit. Auch die Schritte a) und d) werden in kürzerer Zeit durchgeführt als der Schritt c).

Das erfindungsgemäße Verfahren wird weiterhin anhand eines Beispiels detaillierter erläutert.

### Beispiel

Das Verfahren zur Herstellung eines Bor-Emitters auf einem Silizium-Wafer, der in einem Rohrofen angeordnet ist, weist einen Schritt zur Bildung von Borsilikatglas auf dem Silizium-Wafer auf. Der Schritt zur Bildung von Borsilikatglas auf dem Silizium-Wafer ist mehrstufig und wird folgendermaßen durchgeführt: Ein mit mehreren Silizium-Wafern befülltes Waferboot wird in dem Rohrofen bereitgestellt. Der Rohrofen wird auf eine Temperatur von 870°C erhitzt. In einem Schritt a) wird der Rohrofen auf einen vorbestimmten Druck von 0 mbar während einer Zeit von 5 Min. evakuiert. Der Rohrofen wird bei dem Schritt a) bei der Temperatur von 870°C gehalten. An den Schritt a) schließt sich ein Schritt b) an, in dem Edukte, aufweisend BCl₃ und O₂, in den Rohrofen zu einem weiteren vorbestimmten Druck von 50 mbar in einer vorbestimmten Zeit von 30 Sek. eingespült werden, während der Rohrofen bei einer Temperatur von 870°C gehalten wird. Der Gasmengenstrom von O₂ beträgt in dem Schritt b) 1000 sccm, während der Gasmengenstrom von BCl₃ 100 sccm beträgt; N₂ kann als Trägergas verwendet werden. Nach Ablauf der vorbestimmten Zeit wird ein Schritt c) durchgeführt, in dem die Gaszufuhr gestoppt wird und den eingespülten Edukten erlaubt wird, mit sich und einer Oberfläche des Silizium-Wafers über eine vorbestimmte Zeitdauer von 30 Min. zu reagieren, um Borsilikatglas auf der Oberfläche des Silizium-Wafers abzuscheiden. In dem Schritt c) wird der Rohrofen weiterhin bei einer Temperatur von 870°C gehalten. Nach Ablauf der 30 Min. wird der Rohrofen bei einer Temperatur von 870°C 30 Sek. lang mit N₂ mit einem Gasmengenstrom von 5000 sccm gespült. Anschließend wird der Rohrofen bei einer Temperatur von 870°C 1 Min. lang auf einen Druck von 0 mbar evakuiert.

Das Verfahren wird ab dem Schritt b) dreimal wiederholt, um eine gewünschte Borsilikat-Schichtdicke auf dem Silizium-Wafer zu erzeugen. Dann ist der Schritt zur Bildung von Borsilikatglas auf dem Silizium-Wafer durchgeführt.

Zur Herstellung des Bor-Emitters auf dem Silizium-Wafer werden weiterhin folgende Schritte ausgeführt: Nach dem Schritt d) wird ein Schritt e) durchgeführt, in dem N₂ mit einem Gasmengenstrom von 5000 sscm bei einer Temperatur von 980°C und einem Druck von 900 mbar über 15 Min. lang eingetrieben wird. An den Schritt e) schließt sich ein Schritt f) an, in dem eine Oxidation in einem Gemisch aus N₂und O₂ durchgeführt wird. Der Schritt f) wird bei einem Druck von 900 mbar durchgeführt, wobei der Gasmengenstrom von O₂ in dem Schritt f) 10000 sscm beträgt. Der Schritt f) wird bei einer Temperatur von 980° C über 10 Min. lang durchgeführt, anschließend wird die Temperatur auf 990°C erhöht und über 120 Min. beibehalten.

### Bezugszeichenliste:

- 1: Rohrofen
- 2: Zuführrohr
- 3: Silizium-Wafer
- 4: Ende
- 5: Tür
- 6: Totvolumen

## Patentansprüche

1. Verfahren zur Herstellung eines Bor-Emitters auf mindestens einem Silizium-Wafer (3), der in einem Rohrofen (1) angeordnet ist, aufweisend einen Schritt zur Bildung von Borsilikatglas auf dem Silizium-Wafer (3), aufweisend in der angegebenen Reihenfolge
a) Evakuieren des Rohrofens (1) auf einen vorbestimmten Druck,
b) Einspülen von Edukten, aufweisend BCl₃ und O₂, in den Rohrofen (1) und Einstellen auf einen weiteren vorbestimmten Druck,
c) Stoppen des Einspülens nach Ablauf einer vorbestimmten Zeit und Reagierenlassen der eingespülten Edukte mit sich und einer Oberfläche des Silizium-Wafers (3) über eine vorbestimmte Zeitdauer, um eine Schicht mit Borsilikatglas auf der Oberfläche des Silizium-Wafers (3) auszubilden, und
d) Evakuieren des Rohrofens (1) nach Ablauf der vorbestimmten Zeitdauer.

2. Verfahren nach Anspruch 1, **dadurch gekennzeichnet, dass** die Schritte b) bis d) zyklisch wiederholt werden.

3. Verfahren nach Anspruch 1 oder 2, **dadurch gekennzeichnet, dass** der vorbestimmte Druck bis zu 15 mbar, bevorzugt 1 bis 14 mbar, bevorzugter 7 bis 12 mbar beträgt und/oder der weitere vorbestimmte Druck im Bereich von 20 bis 200 mbar, bevorzugt 20 bis 170 mbar, bevorzugter 20 bis 150 mbar liegt.

4. Verfahren nach einem der vorangehenden Ansprüche, **dadurch gekennzeichnet, dass** der Schritt c) bei einer Temperatur im Bereich von 800 bis 1.000°C, bevorzugt 820 bis 950°C, bevorzugter 850 bis 910°C durchgeführt wird.

5. Verfahren nach einem der vorangehenden Ansprüche, **dadurch gekennzeichnet, dass** die vorbestimmte Zeit im Bereich von 10 bis 120 Sek., bevorzugt im Bereich von 20 bis 100 Sek., bevorzugter im Bereich von 30 bis 60 Sek. liegt und/oder dass die vorbestimmte Zeitdauer im Bereich von 2 Min. bis 20 Min., bevorzugt 3 Min. bis 15 Min., bevorzugter 5 Min. bis 10 Min. liegt und/oder der Schritt a) und/oder d) in einer weiteren Zeit im Bereich von 10 bis 120 Sek., bevorzugt im Bereich von 20 bis 100 Sek., bevorzugter im Bereich von 30 bis 60 Sek. durchgeführt werden.

6. Verfahren nach einem der vorangehenden Ansprüche, **dadurch gekennzeichnet, dass** die Edukte in dem Schritt b) derart in den Rohrofen (1) eingespült werden, dass BCl₃ durch ein Zuführrohr mit einem Austrittsende in den Rohrofen (1) eingespült wird und O₂ durch ein weiteres Zuführrohr mit einem Austrittsende in den Rohrofen (1) eingespült wird, so dass sich BCl₃ und O2 in dem Rohrofen (1) an den benachbart zueinander angeordneten Austrittsenden des Zuführrohrs und des weiteren Zuführrohrs in dem Rohrofen (1) mischen.

7. Verfahren nach einem der vorangehenden Ansprüche, **dadurch gekennzeichnet, dass** die Edukte in dem Schritt b) in den Rohrofen (1) derart eingespült werden, dass sie sich in einem Bereich des Rohrofens (1) mischen, in dem der Silizium-Wafer (3) angeordnet ist.

8. Verfahren nach einem der vorangehenden Ansprüche, **dadurch gekennzeichnet, dass** während des Verfahrens mehrere Silizium-Wafer (3) in einem Waferboot in dem Rohrofen (1) angeordnet sind und dem Verfahren gleichzeitig unterzogen werden, wobei der Abstand der Silizium-Wafer (3) zueinander weniger als 5 mm und bevorzugt weniger als 3 mm beträgt.

9. Verfahren nach einem der vorangehenden Ansprüche, **dadurch gekennzeichnet, dass** zwischen den Schritten c) und d) ein weiterer Schritt durchgeführt wird, in dem der Rohrofen (1) mit einem Inertgas gespült wird.

10. Verfahren nach einem der vorangehenden Ansprüche, **dadurch gekennzeichnet, dass** zur Herstellung des Bor-Emitters auf dem Silizium-Wafer (3) nach dem Schritt d) ein Schritt e) Eintreiben von N₂ und nach dem Schritt e) ein Schritt f) Oxidation mit O₂ durchgeführt werden.

## Claims

1. A method for producing a boron emitter on at least one silicon wafer (3) which is arranged in a tube furnace (1), comprising a step for forming borosilicate glass on the silicon wafer (3), comprising in the sequence specified:
a) evacuating the tube furnace (1) to a predetermined pressure,
b) flushing reactants, comprising BCl₃ and O₂, into the tube furnace (1) and adjusting to a further predetermined pressure,
c) stopping the flushing after expiry of a predetermined time and allowing the reactants flushed in to react with each other and with a surface of the silicon wafer (3) over a predetermined duration, to form a layer with borosilicate glass on the surface of the silicon wafer (3), and
d) evacuating the tube furnace (1) after expiry of the predetermined duration.

2. The method as claimed in claim 1, **characterized in that** steps b) to d) are repeated cyclically.

3. The method as claimed in claim 1 or 2, **characterized in that** the predetermined pressure is up to 15 mbar, preferably 1 to 14 mbar, more preferably 7 to 12 mbar and/or the further predetermined pressure is in the range from 20 to 200 mbar, preferably 20 to 170 mbar, more preferably 20 to 150 mbar.

4. The method as claimed in any of the preceding claims, **characterized in that** step c) is carried out at a temperature in the range from 800 to 1.000°C, preferably 820 to 950°C, more preferably 850 to 910°C.

5. The method as claimed in any of the preceding claims, **characterized in that** the predetermined time is in the range from 10 to 120 sec, preferably in the range from 20 to 100 sec, more preferably in the range from 30 to 60 sec and/or **in that** the predetermined duration is in the range from 2 min to 20 min, preferably 3 min to 15 min, more preferably 5 min to 10 min, and/or step a) and/or d) are carried out in a further time in the range from 10 to 120 sec, preferably in the range from 20 to 100 sec, more preferably in the range from 30 to 60 sec.

6. The method as claimed in any of the preceding claims, **characterized in that** the reactants in step b) are flushed into the tube furnace (1) in such a way that BCl₃ is flushed through a supply tube having an outlet end into the tube furnace (1) and O₂ is flushed through a further supply tube having an outlet end into the tube furnace (1), so that BCl₃ and O₂ mix with each other in the tube furnace (1) at the mutually adjacently arranged outlet ends of the supply tube and of the further supply tube in the tube furnace (1).

7. The method as claimed in any of the preceding claims, **characterized in that** the reactants in step b) are flushed into the tube furnace (1) in such a way that they mix with each other in a region of the tube furnace (1) in which the silicon wafer (3) is arranged.

8. The method as claimed in any of the preceding claims, **characterized in that** during the method, multiple silicon wafers (3) are arranged in a wafer boat in the tube furnace (1) and are subjected to the method simultaneously, the distance of the silicon wafers (3) from one another being less than 5 mm and preferably less than 3 mm.

9. The method as claimed in any of the preceding claims, **characterized in that** between steps c) and d), a further step is carried out in which the tube furnace (1) is flushed with an inert gas.

10. The method as claimed in any of the preceding claims, **characterized in that** for producing the boron emitter on the silicon wafer (3), after step d) a step e) of injecting N₂ and after step e) a step f) of oxidizing with O₂ are carried out.

## Revendications

1. Un procédé de production d'un émetteur de bore sur au moins une plaquette de silicium (3) disposée dans un four tubulaire (1), comprenant une étape de formation de verre borosilicaté sur la plaquette de silicium (3), comprenant dans la séquence spécifiée :
a) mettre sous vide du four tubulaire (1) à une pression prédéterminée ;
b) introduire de réactifs comprenant BCl₃ et O₂ dans le four tubulaire (1) et ajuster à une autre pression prédéterminée ;
c) arrêter l'introduction après un temps prédéterminé et laisser réagir les réactifs introduits entre eux et avec une surface de la plaquette de silicium (3) pendant une période prédéterminée afin de former une couche de verre borosilicaté sur la surface de la plaquette de silicium (3) ; et
d) mettre sous vide du four tubulaire (1) après l'écoulement de la période prédéterminée.

2. Le procédé selon la revendication 1, **caractérisé en ce que** les étapes b) à d) sont répétées cycliquement.

3. Le procédé selon la revendication 1 ou 2, **caractérisé en ce que** la pression prédéterminée va jusqu'à 15 mbar, est de préférence comprise entre 1 et 14 mbar, plus particulièrement entre 7 et 12 mbar et/ou l'autre pression prédéterminée est comprise entre 20 à 200 mbar, de préférence entre 20 à 170 mbar, plus particulièrement entre 20 à 150 mbar.

4. Le procédé selon l'une des revendications précédentes, **caractérisé en ce que** l'étape c) est réalisée à une température comprise entre 800 et 1 000 °C, de préférence entre 820 et 950 °C, plus particulièrement entre 850 et 910 °C.

5. Le procédé selon l'une des revendications précédentes, **caractérisé en ce que** le temps prédéterminé est compris entre 10 et 120 sec, de préférence entre 20 et 100 sec, plus particulièrement entre 30 et 60 sec, et/ou **en ce que** la période prédéterminée est comprise entre 2 et 20 min., de préférence entre 3 min et 15 min, plus particulièrement entre 5 min et 10 min et/ou l'étape a) et/ou d) sont réalisées dans un autre temps compris entre 10 et 120 sec, de préférence entre 20 et 100 sec, plus particulièrement entre 30 et 60 sec.

6. Le procédé selon l'une des revendications précédentes, **caractérisé en ce que** les réactifs sont introduits dans le four tubulaire (1) à l'étape b) de sorte que BCl₃ soit introduit dans le four tubulaire (1) par un tuyau d'alimentation muni d'une extrémité de sortie et que O₂ soit introduit dans le four tubulaire (1) par un autre tuyau d'alimentation muni d'une extrémité de sortie, de sorte que BCl₃ et O₂ se mélangent dans le four tubulaire (1) aux extrémités de sortie du tuyau d'alimentation et de l'autre tuyau d'alimentation disposés côte à côte dans le four tubulaire (1).

7. Le procédé selon l'une des revendications précédentes, **caractérisé en ce que** les réactifs sont introduits dans le four tubulaire (1) à l'étape b) de manière à se mélanger dans une zone du four tubulaire (1) dans laquelle la plaquette de silicium (3) est disposée.

8. Le procédé selon l'une des revendications précédentes, **caractérisé en ce que**, pendant le procédé, plusieurs plaquettes de silicium (3) sont disposées dans un porte-plaquettes dans le four tubulaire (1) et sont soumises simultanément au procédé, dans lequel la distance entre les plaquettes de silicium (3) est inférieure à 5 mm et de préférence inférieure à 3 mm.

9. Le procédé selon l'une des revendications précédentes, **caractérisé en ce qu'**une autre étape est réalisée entre les étapes c) et d) dans laquelle le four tubulaire (1) est purgé avec un gaz inerte.

10. Le procédé selon l'une des revendications précédentes, **caractérisé en ce que**, pour produire l'émetteur de bore sur la plaquette de silicium (3), après l'étape d), une étape e) d'injection de N₂ et après l'étape e), une étape f) d'oxydation avec O₂ sont effectuées.
